(19) **Europäisches Patentamt**
**European Patent Office**
**Office européen des brevets**

(11) **EP 4 389 930 A2**

(12) **EUROPEAN PATENT APPLICATION**

(43) Date of publication:
**26.06.2024 Bulletin 2024/26**

(21) Application number: **23216580.3**

(22) Date of filing: **14.12.2023**

(51) International Patent Classification (IPC):
**C23C 16/02** (2006.01)    **C23C 16/04** (2006.01)
**C23C 16/18** (2006.01)    **C23C 16/34** (2006.01)
**C23C 16/455** (2006.01)    **C23C 16/56** (2006.01)

(52) Cooperative Patent Classification (CPC):
**C23C 16/0272; C23C 16/04; C23C 16/18; C23C 16/34; C23C 16/45534; C23C 16/45553; C23C 16/56; H01L 21/0228; H01L 21/28562; H01L 21/76831**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **20.12.2022 KR 20220179866**

(71) Applicants:
• **Samsung Electronics Co., Ltd.**
  **Suwon-si, Gyeonggi-do 16677 (KR)**
• **Incheon National University Research & Business Foundation**
  **Incheon 22012 (KR)**

(72) Inventors:
• **CHO, Eunhyoung**
  **16678 Suwon-si (KR)**
• **LEE, Sunghee**
  **16678 Suwon-si (KR)**
• **LEE, Jeongyub**
  **16678 Suwon-si (KR)**
• **LEE, Hanboram**
  **16678 Suwon-si (KR)**

(74) Representative: **Elkington and Fife LLP**
**Prospect House**
**8 Pembroke Road**
**Sevenoaks, Kent TN13 1XR (GB)**

(54) **METHOD OF SELECTIVELY FORMING LAYER USING ATOMIC LAYER DEPOSITION AND METHOD OF FORMING INTERCONNECT OF SEMICONDUCTOR DEVICE USING THE SAME**

(57)    A method of selectively forming a layer according to atomic layer deposition includes providing a substrate which includes a first region consisting of a first material and having a first surface and a second region consisting of a second material and having a second surface, forming a first reaction inhibition layer on the second surface using a reaction inhibitor selectively adsorbed on the second surface, selectively forming a first deposition layer on the first surface using a first precursor and a first reactant, wherein the first reactant reacts with the first precursor to form an atomic layer and does not react with the reaction inhibitor to form the atomic layer, and converting the first reaction inhibition layer on the second surface into a second deposition layer using a second reactant which reacts with the first reaction inhibition layer to form the atomic layer.

**FIG. 1**

```
┌─────────────────────────────┐
│ PROVIDE SUBSTRATE INCLUDING │──── S10
│ FIRST REGION AND SECOND REGION │
└─────────────────────────────┘
              │
              ▼
┌─────────────────────────────┐
│ FORM FIRST REACTION INHIBITION │──── S20
│ LAYER IN SECOND REGION USING │
│ FIRST REACTION INHIBITOR │
└─────────────────────────────┘
              │
              ▼
┌─────────────────────────────┐
│ FORM FIRST DEPOSITION LAYER IN │──── S30
│ FIRST REGION USING FIRST │
│ PRECURSOR AND FIRST REACTANT │
└─────────────────────────────┘
              │
              ▼
┌─────────────────────────────┐
│ CONVERT FIRST REACTION INHIBITION │──── S40
│ LAYER INTO SECOND DEPOSITION │
│ LAYER USING SECOND REACTANT │
└─────────────────────────────┘
```

EP 4 389 930 A2

**Description**

FIELD OF THE INVENTION

The disclosure relates to a method of selectively forming a layer using atomic layer deposition and a method of forming an interconnect of a semiconductor device using the same.

BACKGROUND OF THE INVENTION

Continuous downscaling of semiconductor devices causes problems related to interconnect resistance. In order to prevent metals from diffusing into interlayer insulating layers from interconnects formed by filling trenches, diffusion barrier layers are generally formed inside trenches through atomic layer deposition (ALD). Since a diffusion barrier layer formed on a bottom of a trench connected to a lower metal layer increases resistance of an entire interconnect, there is a need for a process of removing the diffusion barrier layer or a process of selectively forming a diffusion barrier layer in a region other than a bottom of a trench.

SUMMARY OF THE INVENTION

Provided are a method of selectively forming a layer using atomic layer deposition and a method of forming an interconnect of a semiconductor device using the same.

Additional aspects will be set forth in part in the description which follows and, in part, will be apparent from the description, or may be learned by practice of embodiments of the disclosure.

In accordance with an aspect of the disclosure, a method of selectively forming a layer includes providing a substrate which includes a first region consisting of a first material and having a first surface and a second region consisting of a second material and having a second surface, forming a first reaction inhibition layer on the second surface using a reaction inhibitor selectively adsorbed on the second surface, selectively forming a first deposition layer on the first surface using a first precursor and a first reactant, wherein the first reactant reacts with the first precursor to form an atomic layer and does not react with the reaction inhibitor to form the atomic layer, and converting the first reaction inhibition layer on the second surface into a second deposition layer using a second reactant which reacts with the first reaction inhibition layer to form the atomic layer.

The first material may include an insulator.

The insulator may include, for example, silicon oxide, silicon nitride, silicon oxynitride, or a low dielectric constant material.

The second material may include a conductor.

The conductor may include, for example, copper (Cu), aluminum (Al), tungsten (W), cobalt (Co), silver (Ag), gold (Au), platinum (Pt), iridium (Ir), rhodium (Rh), or ruthenium (Ru).

The reaction inhibitor may include a metal complex including a central metal and an organic ligand.

The central metal of the reaction inhibitor may include, for example, Cu, Al, W, Co, Ag, Au, Pt, Ir, Rh, or Ru.

The organic ligand may include, for example, a $C_5$-$C_{10}$ carbocyclic group unsubstituted or substituted with at least one $C_1$-$C_5$ alkyl group or at least one $C_1$-$C_5$ alkoxy group.

The carbocyclic group may include, for example, cyclopentadiene (Cp), cyclohexadiene (CHD), cyclooctadiene (COD), or benzene (Ph).

The second material may include a metal conductor.

The reaction inhibitor may include a metal complex in which an organic ligand is coupled to a central metal.

The second material and the central metal may include the same metal.

The reaction inhibitor may include $M((R)_nCp)_2$.

M may include Cu, Al, W, Co, Ag, Au, Pt, Ir, Rh, or Ru.

R may include methyl, ethyl, iso-propyl, or tert-butyl.

n may be one of integers from 0 to 5.

The first reactant may include water ($H_2O$), ammonia ($NH_3$), or hydrogen ($H_2$), and the second reactant may include oxygen ($O_2$), $O_2$ plasma, or ozone (Os).

The forming of the first reaction inhibition layer may include alternately supplying the reaction inhibitor onto the substrate and supplying a third reactant onto the substrate one or more times, and then supplying the reaction inhibitor onto the substrate. The reaction inhibitor may include a metal complex which includes a central metal and an organic ligand including a substituent, and the third reactant may react with the organic ligand to convert the substituent. In this case, the substituent may be removed or substituted with a smaller substituent.

The third reactant may include the same material as a material of the first reactant.

In accordance with an aspect of the disclosure, a method of forming an interconnect of a semiconductor device includes providing a substrate including an interlayer insulating layer, the interlayer insulating layer including a via hole configured to expose a lower metal layer and a trench on the via hole, wherein the trench includes a first region connected to the via hole below the trench and a second region configured to expose the interlayer insulating layer, selectively forming a first reaction inhibition layer on the lower metal layer using a reaction inhibitor selectively adsorbed on the lower metal layer, selectively forming a diffusion barrier layer on an upper surface of the interlayer insulating layer and an exposed portion of the interlayer insulating layer using a first precursor and a first reactant, wherein the first reactant reacts with the first precursor to form an atomic layer and does not react with the reaction inhibitor to form an atomic layer, converting the first reaction inhibition layer into a first metal layer using a second reactant which reacts with the reaction inhibitor to form the atomic layer, and forming an upper metal layer in the via hole and the trench in which the diffusion barrier layer and the first metal layer are formed.

The reaction inhibitor may include a metal complex including a central metal and an organic ligand.

The central metal of the reaction inhibitor may include, for example, Cu, Al, W, Co, Ag, Au, Pt, Ir, Rh, or Ru.

The organic ligand may include, for example, a $C_5$-$C_{10}$ carbocyclic group unsubstituted or substituted with at least one $C_1$-$C_5$ alkyl group or $C_1$-$C_5$ alkoxy group. The carbocyclic group may include, for example, Cp, CHD, COD, or benzene (Ph).

The reaction inhibitor and the lower metal layer may include the same metal.

The first precursor may include, for example, $TiCl_4$, $Ti(NMe_2)_4$(TDMAT), $TaCl_5$, or $Ta(OEt)_2$.

The first reactant may include, for example, water ($H_2O$), ammonia ($NH_3$), or hydrogen ($H_2$).

The second reactant may include, for example, oxygen ($O_2$), $O_2$ plasma, or ozone (Os).

The diffusion barrier layer may include, for example, titanium nitride, tantalum nitride, silicon nitride, tungsten nitride, hafnium nitride, molybdenum nitride, Co, Ta, Ti, or a combination thereof.

The forming of the first reaction inhibition layer may include alternately supplying the reaction inhibitor onto the substrate and supplying a third reactant onto the substrate one or more times, and then supplying the reaction inhibitor onto the substrate. The reaction inhibitor may include a metal complex which includes a central metal and an organic ligand including a substituent, and the third reactant may react with the organic ligand to convert the substituent. In this case, the substituent may be removed or substituted with a smaller substituent.

The third reactant may be the same as the first reactant.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a flowchart for describing a method of selectively forming a layer using atomic layer deposition (ALD) according to an embodiment;
FIG. 2 shows conceptual diagrams for describing the embodiment of FIG. 1;
FIG. 3 is a conceptual diagram illustrating a form in which Ru(EtCp)$_2$ is adsorbed on a Ru surface;
FIG. 4 shows diagrams illustrating optimized adsorption structures and adsorption energies of Ru(EtCp)$_2$ and Carish on a Ru surface obtained through density functional theory (DFT) calculation;
FIG. 5 is a graph showing a result of measuring a thickness of Ru according to an exposure time at Carish in Test Example 1;
FIG. 6 is a graph showing a result of measuring a thickness of Ru according to an exposure time at water ($H_2O$) in Test Example 1;
FIG. 7 is a graph showing a result of measuring a thickness of Ru according to an exposure time at Ru(EtCp)$_2$ in Test Example 2;
FIG. 8 is a graph showing a result of measuring a thickness of Ru according to an exposure time at water ($H_2O$) in Test Example 2;
FIG. 9 is a graph showing a result of measuring a thickness of Ru according to an exposure time at Ru(EtCp)$_2$ in Test Example 3;
FIG. 10 is a graph showing a change in selectivity according to the number of ALD cycles in Test Example 3;
FIG. 11 shows diagrams showing simulation results of areal coverage of a Ru surface according to a form of Ru(EtCp)$_2$ adsorbed on the Ru surface;
FIG. 12 is a flowchart for describing a method of selectively forming a layer using an ALD process according to an embodiment;
FIG. 13 shows conceptual diagrams for describing the embodiment of FIG. 12;
FIG. 14 is a graph showing a change in selectivity according to an exposure time at water ($H_2O$) in Test Example 4;
FIG. 15 is a graph showing a change in selectivity according to the number of ALD cycles in Test Example 4; and
FIGS. 16A to 16E are cross-sectional views illustrating a method of forming a metal interconnect of a semiconductor device using an ALD process according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, embodiments may have different forms and should not be construed as being limited to the descriptions set forth herein. Accordingly, embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. Like reference numerals refer to like elements throughout. In the drawings, the size of each element may be exaggerated for clarity and for convenience of description. Embodiments set forth herein are merely examples and various changes may be made therein.

Hereinafter, an expression such as "above" or "on" may include not only the meaning of immediately on/under/to the left/to the right in a contact manner, but also the meaning of "on/under/to the left/to the right in a non-contact manner. A singular form may include a plural form if there is no clear meaning in the context otherwise. Throughout the specification, unless explicitly described to the contrary, the word "comprise" and variations such as "comprises" or "comprising" will be understood to imply the inclusion of stated elements but not the exclusion of any other elements.

The use of the terms "a" and "an" and "the" and similar referents in the context of describing the embodiments (especially in the context of the following claims) are to be construed to cover both the singular and the plural.

The operations of all methods described herein can be performed in any suitable order unless otherwise indicated herein or otherwise clearly contradicted by context.

The use of any and all examples, or example language provided herein, is intended merely to better illuminate the disclosure and does not pose a limitation on the scope of the disclosure unless otherwise claimed.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present. Like numerals refer to like elements throughout.

Spatially relative terms, such as "over," "above," "on," "upper," "below," "under," "beneath," "lower," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

For the sake of brevity, conventional elements to semiconductor devices may or may not be described in detail herein for brevity purposes.

A typical atomic layer deposition (ALD) process may be performed in a cycle manner. In the case of ALD in which a precursor and a reactant react to form an atomic layer, one cycle may generally include four operations. A first operation may include injecting a precursor to be exposed at a to be deposited-layer, and a second operation may include purging and discharging to remove the excessively supplied precursor and by-products. A third operation may include injecting a reactant to be exposed at the to be deposited-layer on which the precursor is adsorbed, and a final operation may include purging and discharging to remove the excessively supplied reactant and by-products. The four operations may constitute a basic cycle for layer growth, and the basic cycle may be repeated to deposit a layer having a required thickness. In the present specification, when it is described that a precursor is injected and a reactant is injected, it may include a meaning of repeating such a cycle.

In the present specification, when an atomic layer or a reaction inhibition layer is formed using only a precursor or reaction inhibitor, a basic cycle may include a first operation of injecting the precursor to be exposed at a to be deposited-layer and a second operation of performing purging and discharging to remove the excessively supplied precursor or reaction inhibitor and by-products. In the present specification, when it is described that a precursor is injected, it may include a meaning of repeating such a cycle.

Hereinafter, a concept of a method of selectively forming a layer using an ALD process according to an aspect will be described in detail.

Through the method of selectively forming a layer using an ALD process according to an embodiment, different layers may be formed in two regions, the two regions being made of different materials, respectively. To this end, in the present embodiment, two types of precursors having selective reactivity with respect to a reactant may be used. A first precursor may react with a first reactant to form a first deposition layer, and a second precursor (or a reaction inhibitor) may react with a second reactant to form a second deposition layer but may not react with the first reactant to form a deposition layer. In this case, the first precursor may be adsorbed in both the first region and the second region, and the second precursor may be selectively adsorbed only on a surface of the second region. That is, the second precursor may be selectively adsorbed in the second region and may not react with the first reactant to form a deposition layer so that the second precursor may serve as a reaction inhibitor that inhibits the first deposition layer from being formed in the second region. While the second precursor serves as a reaction inhibitor to inhibit the first deposition layer from being formed in the second region, the first precursor may react with the first reactant to selectively form the first deposition layer in the first region. After the first deposition layer is formed in the first region, the second reactant reacting with the second precursor may be introduced to selectively form the second deposition layer in the second region.

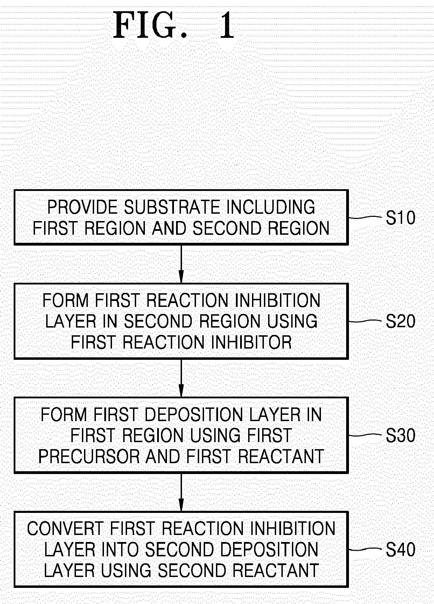

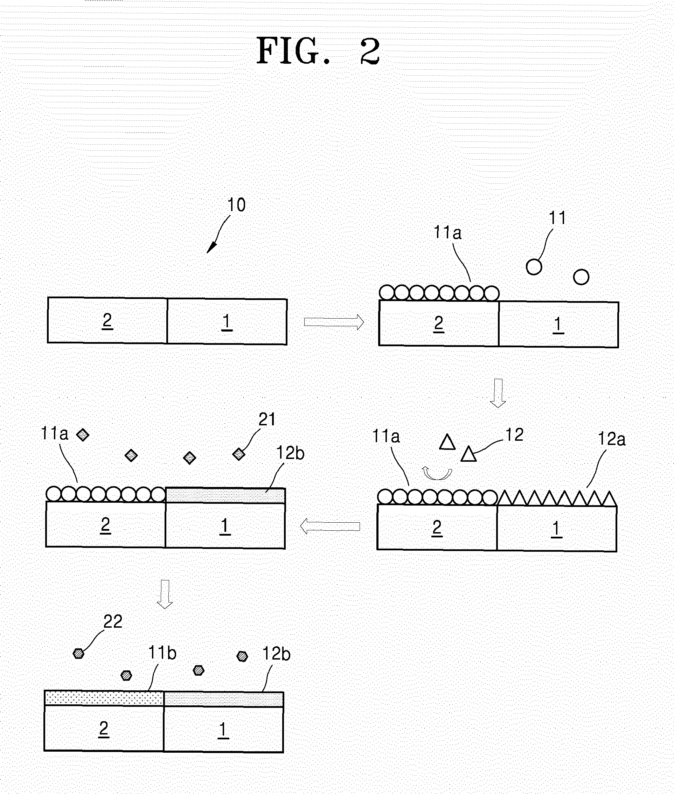

FIG. 1 is a flowchart for describing a method of selectively forming a layer using an ALD process according to an embodiment, and FIG. 2 shows conceptual diagrams for describing the same embodiment.

Referring to FIGS. 1 and 2, a substrate 10 including a first region 1 made of a first material and a second region 2 made of a second material may be provided (S10). The substrate 10 may be provided by being introduced into an ALD apparatus. The first material may be, for example, an insulator. The insulator may include, for example, silicon oxide, silicon nitride, silicon oxynitride, or a low dielectric constant material, but embodiments are not limited thereto. The second material may be, for example, a conductor. The conductor may include, for example, copper (Cu), aluminum (Al), tungsten (W), cobalt (Co), silver (Ag), gold (Au), platinum (Pt), iridium (Ir), rhodium (Rh), or ruthenium (Ru), but embodiments are not limited thereto.

A first reaction inhibition layer 11a may be selectively formed on a surface of the second region 2 through an ALD process using a reaction inhibitor 11 selectively adsorbed on the surface of the second region 2 (S20). The reaction inhibitor 11 may be a material that is selectively adsorbed on the surface of the second region 2 and that selectively reacts with a reactant to thus be usable as a precursor for ALD. The reaction inhibitor 11 may be adsorbed preferentially on the surface of the second region 2 with high selectivity and may not be adsorbed on a surface of the first region 1. The reaction inhibitor 11 may be a metal complex including a central metal and an organic ligand. The central metal may include, for example, Cu, Al, W, Co, Ag, Au, Pt, Ir, Rh, or Ru. The organic ligand may include, for example, a $C_5$-$C_{10}$ carbocyclic group unsubstituted or substituted with at least one $C_1$-$C_5$ alkyl group or at least one $C_1$-$C_5$ alkoxy group. As used herein, the $C_1$-$C_5$ alkyl group may refer to an alkyl group having 1 to 5 carbon atoms. The $C_1$-$C_5$ alkyl group may include, for example, a methyl group, an ethyl group, a propyl group, or a butyl group. The $C_1$-$C_5$ alkoxy group may refer to an alkoxy group having 1 to 5 carbon atoms. The $C_1$-$C_5$ alkoxy group may include, for example, a methoxy group, an ethoxy group, a propoxy group, or a butoxy group. The $C_5$-$C_{10}$ carbocyclic group may refer to a carbocyclic group having 5 to 10 carbon atoms. A carbocyclic group may refer to a cyclic organic compound in which all atoms forming a ring are carbon. The carbocyclic group may include, for example, cyclopentadiene (Cp), cyclohexadiene (CHD), cyclooctadiene (COD), or benzene (Ph).

In an embodiment, the reaction inhibitor 11 may include $M((R)_nCp)_2$. For example, M may include Cu, Al, W, Co, Ag, Au, Pt, Ir, Rh, or Ru, R may include methyl, ethyl, iso-propyl, or tert-butyl, and n may be one of integers from 0 to 5.

In an embodiment, as the central metal, the reaction inhibitor 11 may include the same metal as the conductor of the second region 2.

Next, a first deposition layer 12b may be selectively formed on the surface of the first region 1 through an ALD process using a precursor 12 and a first reactant 21 (S30). Main features of an ALD cycle for forming the first deposition layer 12b will be described. The precursor 12 may be introduced onto the substrate 10 on which the first reaction inhibition layer 11a is formed in the second region 2, and the precursor 12 may be adsorbed on the surface of the first region 1 to form a precursor layer 12a. The precursor 12 may include, for example, $TiCl_4$, $Ti(NMe_2)_4$(TDMAT), $TaCl_5$, $Ta(OEt)_2$, or the like, but embodiments are not limited thereto. The first reactant 21 may be a material that reacts with the precursor 12 to form an atomic layer but does not react with the reaction inhibitor 11 to form an atomic layer. The first reactant 21 may include, for example, water ($H_2O$), ammonia ($NH_3$), or hydrogen ($H_2$), but embodiments are not limited thereto.

Since the surface of the second region 2 is covered by the first reaction inhibition layer 11a, the precursor 12 may not be adsorbed thereon or may be minimized from being adsorbed thereon, and the precursor 12 may instead be adsorbed on the surface of the first region 1. Subsequently, the first reactant 21 may be introduced to react with the precursor 12 or the precursor layer 12a, thereby forming the first deposition layer 12b on the surface of the first region 1. The reaction inhibitor 11 or the first reaction inhibition layer 11a may not react with the first reactant 21 to form an atomic layer.

Then, the first reaction inhibition layer 11a of the second region 2 may be converted into a second deposition layer 11b using a second reactant 22 (S40). The second reactant 22 may be a material capable of reacting with the reaction inhibitor 11 or the first reaction inhibition layer 11a to form an atomic layer. The second reactant 22 may include, for example, oxygen ($O_2$) or ozone (Os). Optionally, oxygen ($O_2$) or ozone (Os) may be an oxygen ($O_2$) or ozone (Os)

plasma.

In an embodiment, the second deposition layer 11b may be made of the same material as the second material constituting the second region 2. Since the first deposition layer 12b is already formed in the first region 1, the first deposition layer 12b may not be affected by the second reactant 22. In FIG. 2, the first deposition layer 12b and the second deposition layer 11b are shown as having the same height, but the first deposition layer 12b and the second deposition layer 11b may be adjusted to have different heights.

As described above, by using a reaction inhibitor as both a reaction inhibitor and a precursor for ALD with respect to a substrate including a first surface and a second surface, through an ALD process, a first deposition layer may be formed on the first surface, and a second deposition layer may be formed on the second surface.

In an existing ALD process, a separate process operation of depositing a first deposition layer on a first surface by applying a reaction inhibitor and then removing the reaction inhibitor may be required. In addition, a reaction inhibition layer may not be completely removed and thus may remain in the form of impurities on an interfacial layer. In addition, a second precursor is separately required to form a second deposition layer on a second surface, and a separate process of adsorbing the second precursor has to be performed. However, a reaction inhibitor proposed in an embodiment may be deposited as a material identical to or different from that of a second surface by a second reactant without needing to be removed after the reaction inhibitor completes a role of a reaction inhibitor. Accordingly, ligands of a reaction inhibitor that are not removed between a second surface and a second deposition layer may not remain in the form of impurities.

Hereinafter, it will be described that bis(ethylcyclopentadienyl)ruthenium(II) (Ru(EtCp)$_2$) is usable as a reaction inhibitor and a precursor in a process of depositing a Ru layer.

A precursor may react with a specific reactant to form an atomic layer. For example, dicarbonyl-bis(5-methyl-2,4-hexanediketonato)ruthenium(II) (e.g., Carish manufactured by TANAKA Kikinzoku Kogyo in Japan), which is a precursor for forming a ruthenium (Ru) layer (hereinafter referred to as a Ru precursor), may react with oxygen (O$_2$), ozone (O$_3$), or water (H$_2$O) to form a Ru layer. Optionally, oxygen (O$_2$) or ozone (Os) may be an oxygen (O$_2$) or ozone (Os) plasma. On the other hand, Ru(EtCp)$_2$, which is another Ru precursor, may react with oxygen (O$_2$) or ozone (Os) to form a Ru layer, but may not react with water (H$_2$O) to form a Ru layer. Therefore, Ru(EtCp)$_2$ may have selective reactivity with respect to oxygen (O$_2$) or ozone (Os) in forming a Ru layer.

A mechanism through which Ru(EtCp)$_2$ serves as a reaction inhibitor may be inferred as follows.

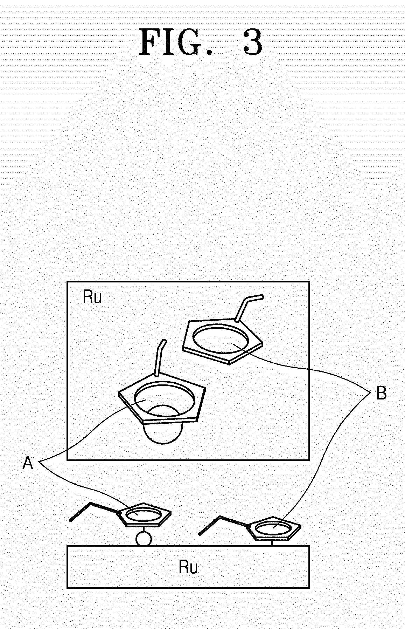

When Ru(EtCp)$_2$ is exposed at an Ru surface, Ru(EtCp)$_2$ may be adsorbed on the Ru surface and may present in the form of EtCp-Ru or EtCp. This is conceptually shown in FIG. 3. Referring to FIG. 3, EtCp-Ru A and EtCp B may be adsorbed on an Ru surface such that a planar surface of a Cp ring is parallel to the Ru surface. Therefore, Ru(EtCp)$_2$ may efficiently cover the Ru surface.

Subsequently, when Carish is exposed at the same Ru surface, it may be difficult for Carish to be adsorbed on the Ru surface due to a steric hindrance of EtCP-Ru and EtCP already adsorbed on the Ru surface. Even when water that reacts with Carish to form Ru is applied, since Carish is hardly adsorbed on the Ru surface and water does not react with Ru(EtCp)$_2$ (or with EtCp-Ru and EtCp adsorbed on the Ru surface) to form Ru, a Ru layer may not be formed on the Ru surface.

On the other hand, when Carish is exposed at the Ru surface on which Ru(EtCp)$_2$ is not adsorbed, since Carish is adsorbed on the Ru surface, Carish may react with water, which is a reactant, to form a Ru layer. Therefore, by using Ru(EtCp)$_2$ as a reaction inhibitor when a Ru layer is formed through a reaction between Carish and water, a selective layer deposition process may be possible through ALD.

As described above, Ru(EtCp)$_2$ having such selective reactivity may be used as both of a reaction inhibitor for ALD and a precursor for ALD according to reactants. When a precursor including a cyclic ligand such as cyclopentadienyl (Cp) is adsorbed on a deposition target surface, since a planar surface of the cyclic ligand covers the deposition target surface to be planar to the deposition target surface, the adsorption of a subsequent precursor may be efficiently inhibited by a steric hindrance of the cyclic ligand. That is, a precursor adsorbed first may serve as a reaction inhibitor for a subsequent precursor (such as Carish).

In addition, after Ru(EtCp)$_2$ serves as a reaction inhibitor for a surface on which Ru(EtCp)$_2$, Ru(EtCp)$_2$ may be converted into a Ru layer through a reaction with an appropriate reactant, for example, oxygen (O$_2$). Through such conversion into the Ru layer, an effect of removing a reaction inhibition layer may be obtained. Since a central metal (Ru) of Ru(EtCp)$_2$ as a reaction inhibitor is the same as a central metal (Ru) of Carish, which is an ALD precursor, and a metal (Ru) of a deposition target surface, it may be expected that the implantation of impurities due to the reaction inhibitor may be minimized.

An energy relationship described below may support a mechanism through which Ru(EtCp)$_2$ serves as a reaction inhibitor.

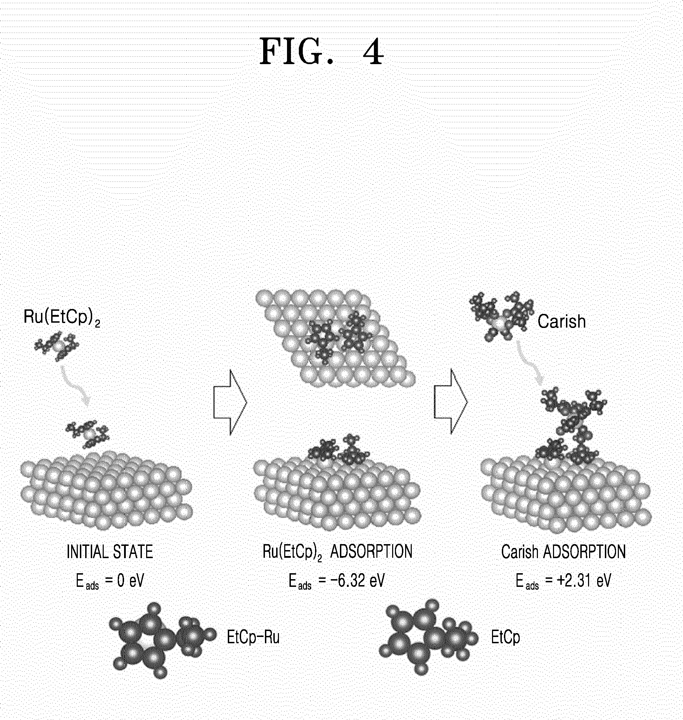

FIG. 4 shows diagrams illustrating optimized adsorption structures and adsorption energies of Ru(EtCp)$_2$ and Carish on a Ru surface obtained through density functional theory (DFT) calculation.

Referring to FIG. 4, an initial state may represent a non-adsorbed Ru surface, and in this case, deposition energy may be about 0 eV. A Ru(EtCp)$_2$ adsorption state may be a state in which Ru(EtCp)$_2$ is adsorbed on a surface in the form of EtCp-Ru and EtCp ligands through a dissociation reaction of the EtCp ligand. A DFT calculation result shows that adsorption energy is about -6.32 eV (<about 0 eV), which shows that adsorption of Ru(EtCp)$_2$ on a Ru surface is favorable. After adsorption of Ru(EtCp)$_2$, the Ru surface may be changed into a surface with an EtCp terminal. Carish which is a precursor for depositing a Ru atomic layer may be exposed at the Ru surface on which a first reaction has been completed as described above. It may be assumed that, while a CO ligand is removed, Carish as a precursor is adsorbed on a surface of the EtCP terminal. Such a result shows that adsorption energy is about +2.31 eV (>about 0 eV), which shows that such a reaction path is unfavorable. That is, when Ru(EtCp)$_2$ is adsorbed on the Ru surface and changed into the EtCP terminal, it means that it is difficult for Carish, which is the precursor for forming a Ru atomic layer, to be adsorbed on the Ru surface. Therefore, such adsorption energy indicates that Ru(EtCP)$_2$ is usable as a reaction inhibitor for deposition of a Ru atomic layer by Carish.

Hereinafter, a growth behavior of a Ru layer was evaluated by performing an ALD process using Carish and water (H$_2$O) and using Ru(EtCP)$_2$ and water (H$_2$O).

Test Example 1: Ru layer formation test using Carish and water

200 cycles of an ALD process were performed on a 15-nm SiO$_2$/Ru substrate using Carish as a Ru precursor and water (H$_2$O) as a reactant, and then a thickness of Ru was measured. Specifically, Carish was injected into an ALD chamber at a temperature of 283 °C and a pressure of 100 mTorr for a certain time to then perform purging, water was injected at the same temperature and pressure for a certain time to then perform purging, so that the SiO$_2$/Ru substrate was sequentially exposed to Carish and water, thereby performing one cycle of ALD. In this case, 200 cycles were each performed by changing an exposure time to Carish and an exposure time to water, and then the thickness of Ru on the SiO$_2$/Ru substrate was measured.

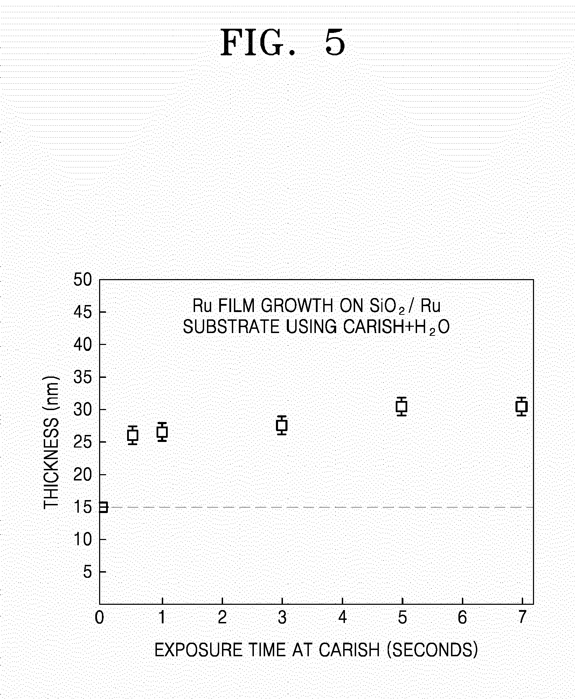

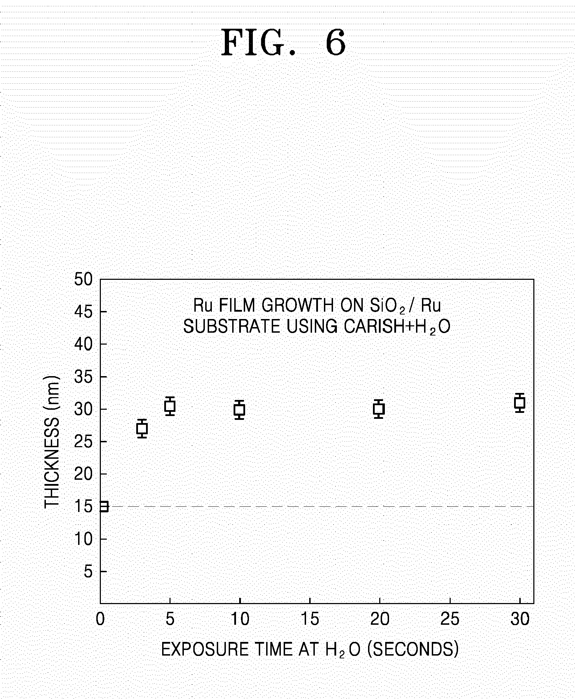

FIG. 5 is a graph showing a result of measuring the thickness of Ru according to a change in exposure time to Carish. In this case, the exposure time to water (H$_2$O) was constant and was 5 seconds. FIG. 6 is a graph showing a result of measuring the thickness of Ru according to a change in exposure time to water (H$_2$O). In this case, the exposure time to Carish was constant and was 5 seconds. Referring to Fig. 5, when the exposure time to Carish is changed between 0.5 seconds and 7 seconds, the total thickness of Ru on the SiO$_2$ substrate may be in a range of about 26 nm to about 30 nm. Referring to FIG. 6, when the exposure time to water is changed between 3 seconds and 30 seconds, the total thickness of Ru on the SiO$_2$ substrate may be in a range of about 27 nm to about 31 nm. Considering that an initial thickness of Ru on the SiO$_2$ substrate is 15 nm, it may be seen that a Ru layer having a thickness of about 11 nm to 16 nm has been formed through ALD using Carish and water in Test Example 1.

Test Example 2: Ru layer formation test using Ru(EtCp)$_2$ and water

A SiO$_2$/Ru substrate was treated in the same manner as in Test Example 1, except that Ru(EtCp)$_2$ was used instead of Carish. A thickness of Ru on the SiO$_2$/Ru substrate was measured after 200 cycles were each performed by changing an exposure time to Ru(EtCp)$_2$ and an exposure time at water.

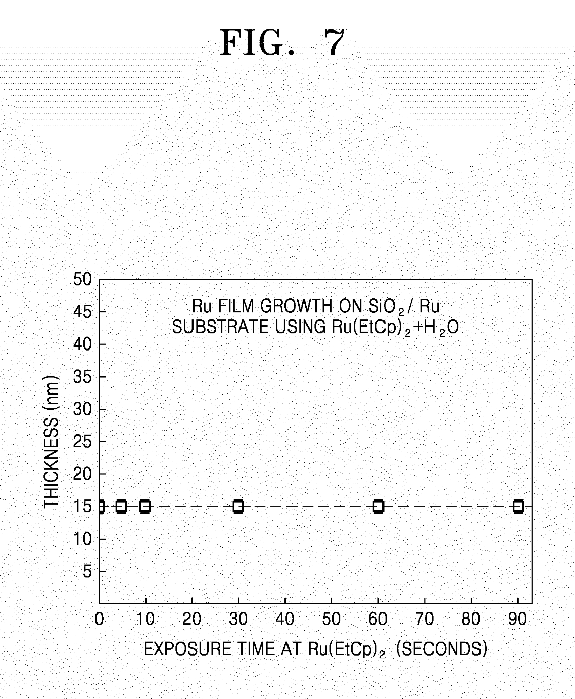

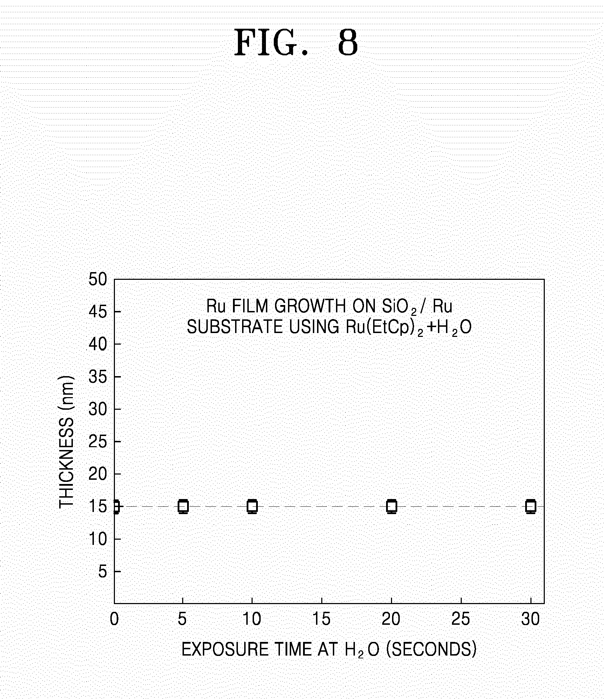

FIG. 7 is a graph showing a result of measuring the thickness of Ru according to a change in exposure time to Ru(EtCp)$_2$. In this case, the exposure time to water was constant and was 5 seconds. FIG. 8 is a graph showing a result of the thickness of Ru according to a change in exposure time to water (H$_2$O). In this case, the exposure time to Ru(EtCp)$_2$ was constant and was 5 seconds. Referring to FIGS. 7 and 8, when the exposure time to Ru(EtCp)$_2$ is changed between 5 seconds and 90 seconds and the exposure time to water is changed between 5 seconds and 30 seconds, the total thickness of a Ru layer may not be changed from 15 nm. Considering that an initial thickness of Ru on the SiO$_2$ substrate is 15 nm, it may be seen that a Ru layer has not been formed through an ALD process using Ru(EtCp)$_2$ and water. Thus, when Ru(EtCP)$_2$ is adsorbed on the Ru substrate, since, in a subsequent Ru ALD process using water (H$_2$O) as a reactant, Ru(EtCP)$_2$ hinders adsorption of a Carish precursor and does not react with water (H$_2$O) to form a layer, it may be seen that Ru(EtCP)$_2$ is usable as an effective reaction inhibitor.

Test Example 3: Evaluation I of layer formation blocking properties of Ru(EtCp)$_2$

The layer formation blocking properties of Ru(EtCp)$_2$ as a reaction inhibitor were evaluated using selectivity.

Selectivity S for evaluating the layer formation blocking properties may be represented by Equation 1 below:

$$S = \frac{R_{gs} - R_{ns}}{R_{gs} + R_{ns}}$$ (Equation 1).

Here, $R_{gs}$ denotes a thickness of a layer grown in a region (growth region) in which a layer may grow without being hindered, and $R_{ns}$ denotes a thickness of a layer grown in a region (non-growth region) in which layer growth is hindered by a reaction inhibitor.

When selectivity S is 1, it means that the blocking properties of the reaction inhibitor is perfect (100%) so that a layer is not formed in the non-growth region, and when selectivity S is 0, it means that the reaction inhibitor has no blocking properties (0%) so that a layer is formed in the non-growth region at the same rate as in the growth area.

(1) $R_{gs}$ measurement (200 cycles)

By using a method of Test Example 1, a Ru layer was formed on a $SiO_2$/Ru substrate through a reaction of Carish and water, and then a thickness of a layer was measured. In this case, an exposure time at Carish was 5 seconds, and an exposure time at water was 5 seconds. A thickness of a grown Ru layer was 15 nm, which corresponded to $R_{gs}$.

(2) $R_{ns}$ measurement (according to change in exposure time at $Ru(EtCp)_2$)

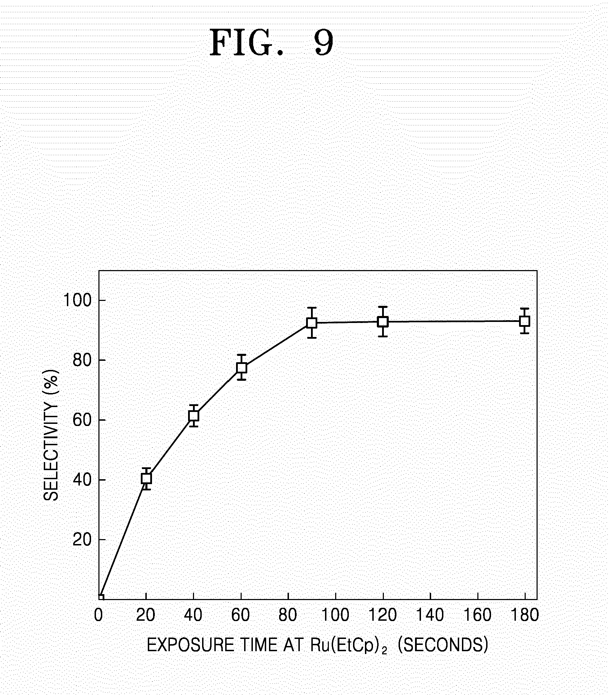

First, after a $SiO_2$/Ru substrate was treated with $Ru(EtCp)_2$, by using the method of Test Example 1, a Ru layer was formed through a reaction of Carish and water, and then a thickness of the Ru layer was measured. During the treatment with $Ru(EtCp)_2$, the exposure time at $Ru(EtCp)_2$ was changed into 20 seconds, 40 seconds, 60 seconds, 90 seconds, 120 seconds, and 180 seconds, and the thickness of the Ru layer formed by Carish as a precursor was measured in each case. In each case, the number of cycles during the treatment with $Ru(EtCp)_2$ was one. $R_{ns}$ measured (according to an exposure time) as described above and selectivity (S) according thereto are shown in Table 1 and FIG. 9.

[Table 1]

| Exposure time at Ru $(EtCp)_2$ (sec) | $R_{ns}$ (nm) (exposure time) | S (%) ($R_{gs}$=15 nm) |
|---|---|---|
| 20 | 6.43 | 40 |
| 40 | 3.63 | 61 |
| 60 | 1.85 | 78 |
| 90 | 0.71 | 91 |
| 100 | 0.69 | 91.2 |
| 120 | 0.79 | 90 |
| 180 | 0.77 | 90.2 |

(3) $R_{gs}$ measurement (according to change in number of cycles of Carish+water)

By using the method of Test Example 1, a Ru layer was formed on a $SiO_2$/Ru substrate through a reaction of Carish and water, and a thickness of the Ru layer was measured for each of 50, 100, 200, 300, 400, and 500 ALD cycles. In this case, an exposure time at Carish was 5 seconds, and an exposure time at water was 5 seconds.

(4) $R_{ns}$ measurement (according to change in number of cycles of Carish+water)

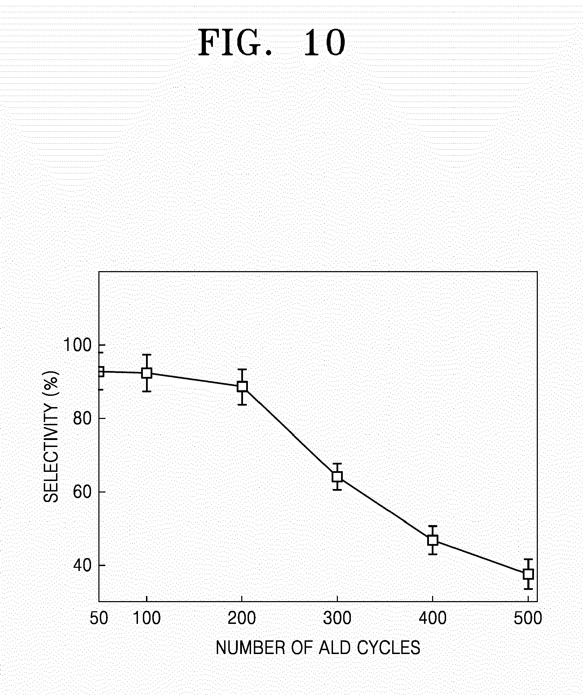

First, after a $SiO_2$/Ru substrate was treated with $Ru(EtCp)_2$, by using the method of Test Example 1, a Ru layer was formed through a reaction of Carish and water, and then a thickness of the Ru layer was measured. In this case, 50, 100, 200, 300, 400, and 500 ALD cycles of Carish+water were performed to measure a thickness of a layer formed for each case. During the treatment with $Ru(EtCp)_2$, an exposure time at $Ru(EtCp)_2$ was 90 seconds. $R_{ns}$ (cycle) as described above and selectivity (S) according thereto are shown in Table 2 and FIG. 10. In Table 2, $R_{gs}$ was changed in a range of 3.75 mm to 37.5 nm according to the number of ADL cycles.

[Table 2]

| Number of ALD cycl es | $R_{ns}$ (nm) (cycle) | S (%) ($R_{gs}$=3.75 nm to 37. 5nm) |
|---|---|---|
| 50 | 0.14 | 93 |
| 100 | 0.31 | 92 |
| 200 | 0.79 | 90 |
| 300 | 4.77 | 65 |
| 400 | 10.82 | 47 |
| 500 | 16.85 | 38 |

Referring to Table 1 and FIG. 9, as the exposure time at $Ru(EtCp)_2$ increases in a treatment process using $Ru(EtCp)_2$, the selectivity (S) may increase, and then, when the exposure time is 90 seconds, the selectivity may converges to about 92%. This means that, as the exposure time at $Ru(EtCp)_2$ increases, an adsorption density of $Ru(EtCp)_2$ on the $SiO_2$/Ru substrate increases, thereby increasing layer formation blocking properties.

Referring to Table 2 and FIG. 10, in an ALD process using Carish+water, as the number of ALD cycles increases, the blocking properties of $Ru(EtCp)_2$ decrease. The selectivity is about 90% in ALD 200 cycles but rapidly decreases to about 64% in ALD 300 cycles and rapidly decreases to about 38% in ALD 500 cycles.

As a reason why the blocking properties of $Ru(EtCp)_2$ decrease as the number of ALD cycles increases, it may be assumed that, firstly, Carish as a precursor reacts with a $Ru(EtCp)_2$-adsorbed surface, or secondly, Ru nucleation occurs at a defect site on the $Ru(EtCp)_2$-adsorbed surface.

Regarding such a first assumption, adsorption energy was calculated through a simulation on whether Carish reacts with the $Ru(EtCp)_2$-adsorbed surface. To this end, it was assumed that EtCp-Ru and EtCp adsorbed on a Ru surface were hydrolyzed into OHCp-Ru and OHCp by reacting with water in a Ru ALD process using Carish and water. OH refers to a hydroxyl group. In addition, it was assumed that, when Carish as a precursor approached a surface having an OHCp terminal, while a CO ligand of Carish was removed, by-products were formed through a coordination bond with an OH group. Under such assumptions, adsorption energy of OHCp-Ru and OHCp on the Ru surface was calculated to be -0.33 eV (<0 eV), and adsorption energy of Carish on an OHCp-Ru and OHCp adsorption surface was calculated to be +3.29 eV (>0 eV). Such calculation results show that, after $Ru(EtCp)_2$ is adsorbed on the Ru surface as EtCp-Ru and EtCp, EtCp-Ru and EtCp react with water to be converted into OHCp-Ru and OHCp (adsorption energy<0 eV), but Carish does not react with OHCp-Ru and EtCp (adsorption energy>0 eV).

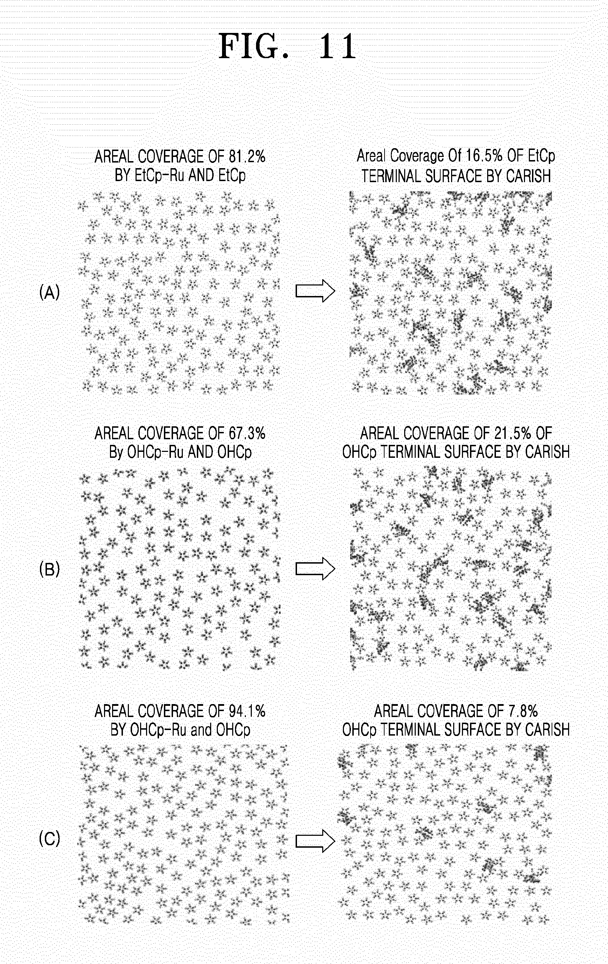

Regarding such a second assumption, adsorption coverage by $Ru(EtCp)_2$ was calculated using a Monte Carlo (MC) simulation based on an adsorption structure through DFT calculation. When $Ru(EtCp)_2$ was adsorbed, in a case A in which EtCp-Ru and EtCp covered the Ru surface as much as possible through physical adsorption, a case B in which both of EtCp-Ru and EtCp covering the Ru surface reacted with water to be converted into OHCp-Ru and OHCp, and a case C in which OHCp-Ru and OHCp covered the Ru surface as much as possible through physical adsorption, areal coverage of the Ru surface was calculated. FIG. 11 shows diagrams illustrating simulation results in the cases A, B, and C.

Referring to FIG. 11, in the case A, areal coverage of the Ru surface by EtCp-Ru and EtCp may be calculated to be 81.2 %. Although vacancies are still present on the Ru surface, the vacancies may not be occupied due to a steric hindrance between $Ru(EtCp)_2$ molecules. The vacancy may be regarded as a potential site at which Carish as a precursor may be adsorbed in a subsequent Ru ALD process. Areal coverage by Carish on a reaction inhibition layer (EtCp-Ru and EtCp) was calculated to be 16.5% through an MC simulation. In addition, as described above, when water ($H_2O$) is applied, a surface of an EtCP terminal of the Ru surface may be converted to a surface of an OHCp terminal. Since OHCp is smaller than EtCp, in this case, areal coverage decreases, and thus a density of vacancies not occupied by a reaction inhibitor increases. Referring to FIG. 11, in the case B, areal coverage by OHCp-Ru and OHCp decreased to 67.3%, and areal coverage by Carish on such a surface increased to 25.1%.

Such calculation results may explain why a layer formation blocking effect by $Ru(EtCp)_2$ decreases as a Ru ALD cycle increases in Test Example 3. As the number of Ru ALD cycles increases, a rate at which EtCp-Ru and EtCp on the Ru surface are converted into OHCp-Ru and OHCp by introduced water ($H_2O$) may increase, and as a result, areal coverage of the Ru surface may decrease so that vacancies may increase. When Carish is adsorbed in the vacancies to form Ru nuclei, a layer formation blocking effect by $Ru(EtCp)_2$ may decrease.

Hereinafter, a method of improving selectivity of $Ru(EtCp)_2$ will be described.

Referring to FIG. 11 again, in the case C in which OHCp-Ru and OHCp cover the Ru surface as much as possible, areal coverage of the Ru surface may be 94.1%, which is an increase from 82.1% in the case A. Therefore, it may be seen that, when the Ru surface is adsorbed with both of OHCp-Ru and OHCp, a layer formation blocking effect by Ru(EtCp)$_2$ may be improved. To this end, a process of adsorbing Ru(EtCp)$_2$ on a Ru surface, applying water (H$_2$O) to convert EtCp-Ru and EtCp into OHCp-Ru and OHCp to generate an empty space in the Ru surface, adsorbing Ru(EtCp)$_2$ thereon again, and then applying water (H$_2$O) may be repeated to increase areal coverage.

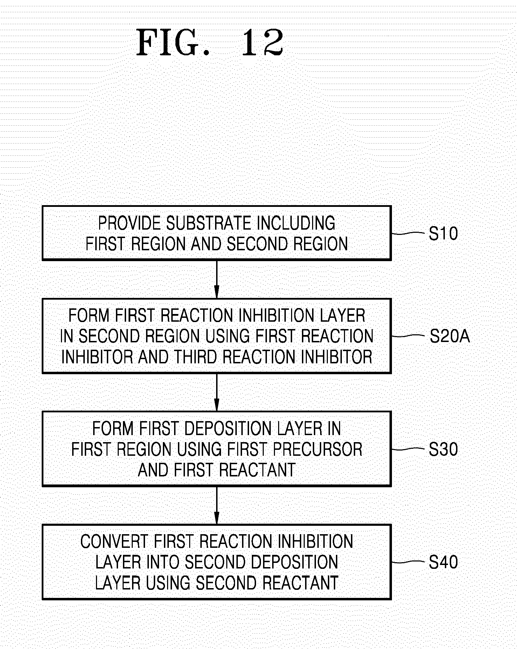

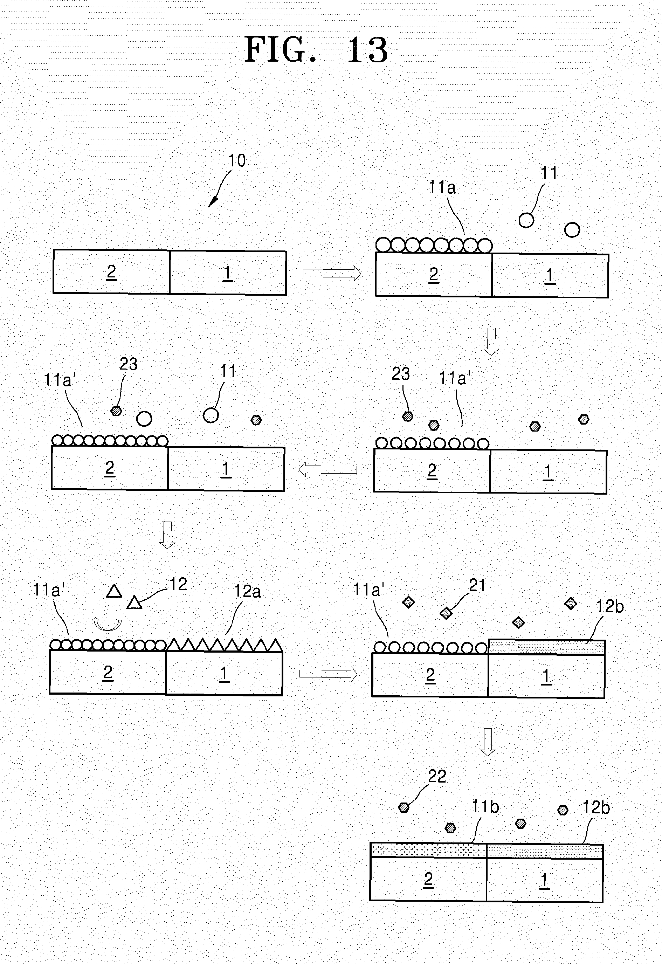

FIG. 12 is a flowchart for describing a method of selectively forming a layer using an ALD process according to an embodiment, and FIG. 13 shows conceptual diagrams for describing the same embodiment. A configuration of the method of selectively forming a layer according to the present embodiment is the same as that of the method of selectively forming a layer described with reference to FIGS. 1 and 2, except that operation S20A of forming a first reaction inhibition layer in the method of selectively forming a layer according to the present embodiment is different from operation S20 of forming the first reaction inhibition layer in the method of selectively forming a layer according to the present embodiment described with reference to FIGS. 1 and 2.

Referring to FIGS. 12 and 13, a substrate 10 including a first region 1 made of a first material and a second region 2 made of a second material may be provided (S10). The substrate 10 may be provided by being introduced into an ALD apparatus. The first material may be, for example, an insulator. The insulator may include, for example, silicon oxide, silicon nitride, silicon oxynitride, or a low dielectric constant material, but embodiments are not limited thereto. The second material may be, for example, a conductor. The conductor may include, for example, copper (Cu), aluminum (Al), tungsten (W), cobalt (Co), silver (Ag), gold (Au), platinum (Pt), iridium (Ir), rhodium (Rh)), or ruthenium (Ru), but embodiments are not limited thereto.

A second reaction inhibition layer 11a' may be selectively formed on a surface of the second region 2 through an ALD process using a third reactant 23 and a reaction inhibitor 11 selectively adsorbed on the surface of the second region 2 (S20A). The reaction inhibitor 11 may be a material that is selectively adsorbed on the surface of the second region 2 and selectively reacts with a reactant to thus be usable as a precursor for ALD. The reaction inhibitor 11 may be adsorbed preferentially on the surface of the second region 2 with high selectivity and may not be adsorbed on a surface of the first region 1. The reaction inhibitor 11 may be a metal complex including a central metal and an organic ligand having substituents. The central metal may include, for example, Cu, Al, W, Co, Ag, Au, Pt, Ir, Rh, or Ru. The organic ligand may include, for example, a C$_5$-C$_{10}$ carbocyclic group substituted with at least one C$_1$-C$_5$ alkyl group or at least one C$_1$-C$_5$ alkoxy group. The carbocyclic group may include, for example, Cp, CHD, COD, or benzene (Ph). In an embodiment, the reaction inhibitor may include M((R)$_n$Cp)$_2$. M may include Cu, Al, W, Co, Ag, Au, Pt, Ir, Rh, or Ru, R may include methyl, ethyl, iso-propyl, or tert-butyl, and n may be one of integers from 1 to 5. In one embodiment, as the central metal, the reaction inhibitor 11 may include the same metal as the conductor of the second region 2.

The reaction inhibitor 11 may react with an appropriate reactant so that the substituent of the organic ligand may be removed or substituted with a substituent having a smaller size. When the substituent is removed from the reaction inhibitor 11 or substituted with a smaller substituent, an area occupied by molecules may be reduced. The third reactant 23 may be a material that does not react with the reaction inhibitor 11 to form an atomic layer, but removes the substituent of the reaction inhibitor 11 or substitute the substituent with a substituent having a smaller size. The third reactant 23 may include, for example, water (H$_2$O), ammonia (NH$_3$), or hydrogen (H$_2$), but embodiments are not limited thereto.

An operation of injecting the reaction inhibitor 11 and an operation of injecting the third reactant 23 may be alternately performed to form a second reaction inhibition layer 11a'. Optionally, the operation of injecting the reaction inhibitor 11 may be performed finally. In other words, the last injection to be performed may be that of the reaction inhibitor 11. In order to form the second reaction inhibition layer 11a', for example, the reaction inhibitor 11 may be injected, the third reactant 23 may be injected, and the reaction inhibitor 11 may be injected.

The substrate 10 may be exposed to the reaction inhibitor 11, and thus the second reaction inhibition layer 11a' may be formed. The first reaction inhibition layer 11a may include spaces between molecules adsorbed on the surface of the second region 2. Therefore, areal coverage of the surface of the second region 2 by the first reaction inhibition layer 11a may be less than 100%. Subsequently, when the substrate 10 is exposed to the third reactant 23, the substituent of the reaction inhibitor 11 included in the first reaction inhibition layer 11a may react with the third reactant 23 to be removed. When the substituent is removed from in the first reaction inhibition layer 11a or is substituted with another small substituent, the areal coverage of the surface of the second region 2 may decrease by as much as a difference in an area occupied by an original substituent so that an empty space may increase. Subsequently, when the substrate 10 is exposed to the reaction inhibitor 11 again, the reaction inhibitor 11 may be further adsorbed to the increased empty space on the surface of the second region 2. Through such a process, as a result, the second reaction inhibition layer 11a' may be formed, and the areal coverage of the surface of the second region 2 may be increased.

Some of the substituents included in the first reaction inhibition layer 11a may be removed or substituted with smaller substituents, and the empty space between molecules may be decreased so that the second reaction inhibition layer 11a' may become a layer of which surface areal coverage is improved as compared with the first reaction inhibition layer 11a. The second reaction inhibition layer 11a' may be regarded as a layer having a higher layer density than the first reaction inhibition layer 11a.

Next, a first deposition layer 12b may be selectively formed on the surface of the first region 1 through an ALD process using a precursor 12 and a first reactant 21 (S30). To this end, the precursor 12 may be introduced onto the substrate 10 on which the second reaction inhibition layer 11a' is formed in the second region 2, and the precursor 12 may be adsorbed on the surface of the first region 1 to form a precursor layer 12a. The precursor 12 may include, for example, $TiCl_4$, $Ti(NMe_2)_4$(TDMAT), $TaCl_5$, $Ta(OEt)_2$, or the like, but embodiments are not limited thereto. The first reactant 21 may be a material that reacts with the precursor 12 to form an atomic layer but does not react with the reaction inhibitor 11 to form an atomic layer. The first reactant 21 may include, for example, water ($H_2O$), ammonia ($NH_3$), or hydrogen ($H_2$), but embodiments are not limited thereto. In an embodiment, the first reactant 21 may be the same material as the third reactant 23.

Since the surface of the second region 2 is covered by the first reaction inhibition layer 11a, the precursor 12 may not be adsorbed thereon or may be minimized from being adsorbed thereon, and the precursor 12 may be adsorbed only on the surface of the first region 1. Subsequently, the first reactant 21 may be introduced to react with the precursor 12 or the precursor layer 12a, thereby forming the first deposition layer 12b on the surface of the first region 1. In this case, the reaction inhibitor 11 or the second reaction inhibition layer 11a' may not react with the first reactant 21 to form a thin layer.

Then, the second reaction inhibition layer 11a' of the second region 2 may be converted into a second deposition layer 11b using a second reactant 22 (S40). The second reactant 22 may be a material capable of reacting with the reaction inhibitor 11 or the second reaction inhibitor layer 11a' to form an atomic layer. The second reactant 22 may include, for example, oxygen ($O_2$) or ozone (Os). Optionally, oxygen ($O_2$) or ozone (Os) may be an oxygen ($O_2$) or ozone (Os) plasma.

In an embodiment, the second deposition layer 11b may be made of the same material as the second material constituting the second region 2. Since the first deposition layer 12b is already formed in the first region 1, the first deposition layer 12b may not be affected by the second reactant 22. In FIG. 13, the first deposition layer 12b and the second deposition layer 11b are shown as having the same height, but the first deposition layer 12b and the second deposition layer 11b may be adjusted to have different heights.

As described above, in an embodiment, a reaction inhibitor may be selectively adsorbed on a second surface and may serve as both a reaction inhibitor for a reaction of forming a first deposition layer and a precursor for a reaction of forming a second deposited layer. Accordingly, through an ALD process, the first deposition layer may be formed on a first surface, and the second deposition layer may be formed on the second surface.

Test Example 4: Evaluation II of layer formation blocking properties of $Ru(EtCp)_2$

(1) $R_{gs}$ measurement (200 cycles)

$R_{gs}$ was measured in the same manner as in (1) of Test Example 3.

(2) $R_{ns}$ measurement (according to change in exposure time at water ($H_2O$)

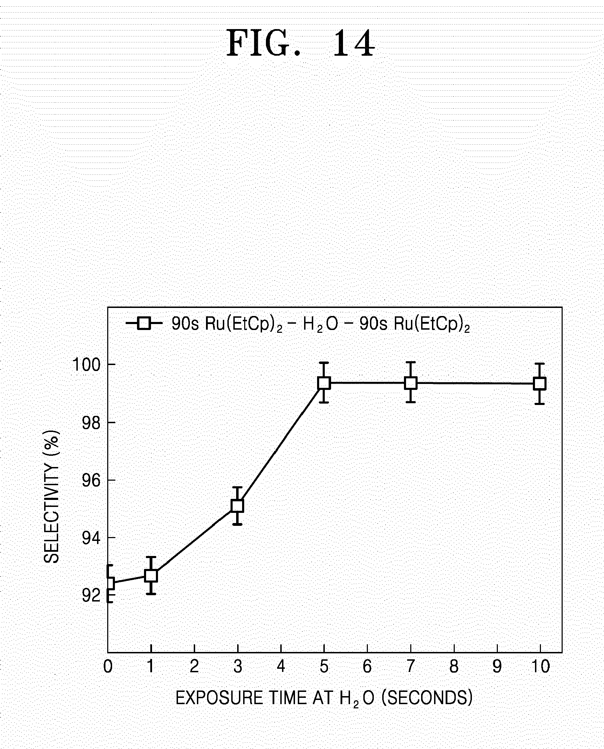

An ALD process was performed on a 15-nm $SiO_2$/Ru substrate using $Ru(EtCp)_2$ and water ($H_2O$) as a reactant. Specifically, $Ru(EtCp)_2$ was injected into an ALD chamber at a temperature of 283 °C and a pressure of 100 mTorr for 90 seconds and then purged, water ($H_2O$) was injected at the same temperature and pressure for a certain time and then purged, and $Ru(ETCP)_2$ was injected for 90 seconds and then purged. In this case, by using the method of Test Example 1, a Ru layer was formed through a reaction of Carish and water on each substrate treated with $Ru(EtCp)_2$ by changing an exposure time to water ($H_2O$) into 0 seconds, 1 second, 3 seconds, 5 seconds, 7 seconds, and 10 seconds, and then a thickness of the Ru layer was measured. $R_{ns}$ measured (according to an exposure time at $H_2O$) as described above and selectivity (S) according thereto are shown in Table 1 and FIG. 14.

[Table 3]

| Exposure time (seconds) at $H_2O$ | $R_{ns}$ (nm) (exposure time) | S (%) ($R_{qs}$=15 nm) |
|---|---|---|
| 0 | 0.61 | 92.2 |
| 1 | 0.58 | 92.5 |
| 3 | 0.38 | 95 |
| 5 | 0.06 | 99.2 |
| 7 | 0.06 | 99.2 |

(continued)

| Exposure time (seconds) at $H_2O$ | $R_{ns}$ (nm) (exposure time) | S (%) ($R_{qs}$=15 nm) |
|---|---|---|
| 10 | 0.07 | 99.1 |

(3) $R_{gs}$ measurement (according to change in number of cycles of Carish+water)

By using the method of Test Example 1, a Ru layer was formed on a $SiO_2$/Ru substrate through a reaction of Carish and water, and a thickness of the Ru layer was measured for each of 50, 100, 200, 300, 400, and 500 ALD cycles. In this case, an exposure time to Carish was 5 seconds, and an exposure time to water was 5 seconds.

(4) $R_{ns}$ measurement (according to change in number of cycles of Carish+water)

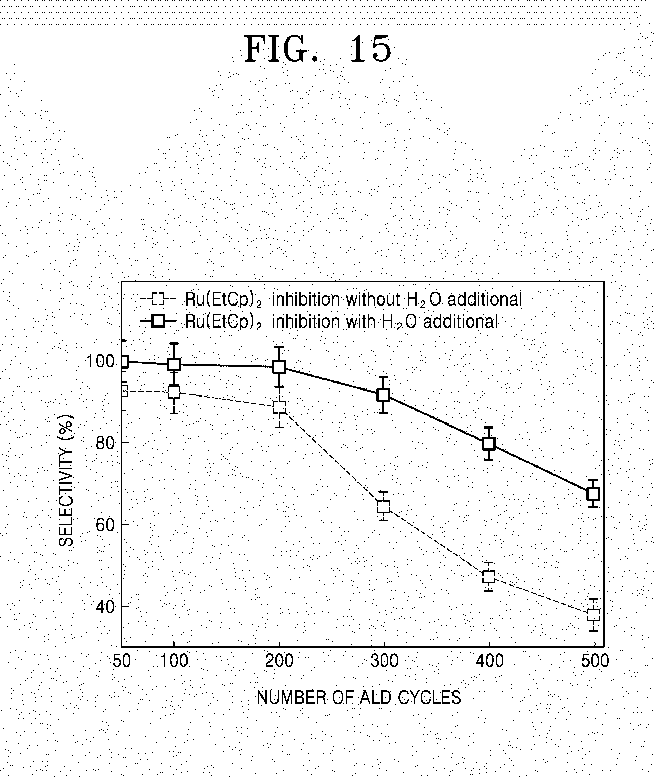

After a 15-nm $SiO_2$/Ru substrate was treated with $Ru(EtCp)_2$ by setting an exposure time to water ($H_2O$) to 5 seconds in a method of (2) above, by using the method of Test Example 1, a Ru layer was formed through a reaction of Carish and water, and then a thickness of the Ru layer was measured. In this case, 50, 100, 200, 300, 400, and 500 ALD cycles of Carish+water were performed to measure a thickness of a layer formed for each case. $R_{ns}$ (cycle+water) measured as described above and selectivity (S) according thereto are shown in Table 4 and FIG. 15. In this case, the selectivity measured in Test Example 3 when water is not used is also shown in FIG. 15.

[Table 4]

| Number of ALD cycles | $R_{ns}$ (nm) (cycle+water) | S (%) ($R_{gs}$=3.75 nm to 37.5nm) |
|---|---|---|
| 50 | 0.00 | 100 |
| 100 | 0.01 | 99.8 |
| 200 | 0.03 | 99.6 |
| 300 | 0.94 | 92 |
| 400 | 3.35 | 79.9 |
| 500 | 6.62 | 70 |

Referring to Table 3 and FIG. 14, when an exposure time at water ($H_2O$) is 5 seconds during treatment with $Ru(EtCp)_2$, selectivity is shown as converging to about 99 %. Thus, during the treatment with $Ru(EtCp)_2$, an appropriate exposure time at water ($H_2O$) may be determined.

Referring to Table 4 and FIG. 15, when water ($H_2O$) is used concurrently when a reaction inhibitor layer is formed using $Ru(EtCp)_2$, selectivity is shown as being maintained at 90 % or more up to 300 cycles. On the other hand, when a reaction inhibition layer is formed using only $Ru(EtCp)_2$ without using water ($H_2O$), selectivity drops to about 67 % at 300 cycles. Referring to FIG. 15, when water ($H_2O$) is used for all ALD cycles, selectivity is higher than a case in which water ($H_2O$) is not used. This is considered to occur because an adsorption density of a reaction inhibitor is improved in a process using water ($H_2O$) as described above. When selectivity is high, a thicker deposition layer may be formed on a desired surface without affecting a surface to be blocked.

Hereinafter, a method of forming a metal interconnect of a semiconductor device according to an aspect of the disclosure, to which the above-described method of selectively forming a layer using an ALD process is applied, will be described in detail.

A metal interconnect positioned at a back-end-of-line in a semiconductor element may serve to transmit an external electric signal to an integrated circuit at a front-end-of-line. As semiconductor elements are miniaturized, line widths of interconnects are gradually reduced, and more metal layers are used in interconnects. In such a process, there are problems such as an increase in interconnect resistance, an RC delay, time-dependent dielectric breakdown (TDDB), electromigration, and metal diffusion. In order to solve the problems, new interconnect materials such as cobalt and ruthenium which replace copper are being researched.

A diffusion barrier layer may be used to prevent an interconnect metal from diffusing into an interlayer insulating layer. In miniaturization of semiconductor elements, a diffusion barrier layer may not become thinner in proportion to a size of an interconnect so as to have a thickness that is less than a minimum thickness for preventing metal diffusion, thereby affecting resistance of the interconnect. In addition, in a case in which a via connected to a lower metal layer and an upper metal layer filling a trench are formed at the same time, when a diffusion barrier layer is formed down to a bottom of the via, series resistance of an interconnect may increase. Therefore, when a diffusion barrier layer on a bottom of a via is etched and removed, or a diffusion barrier layer is formed through ALD, a method of selectively depositing a reaction inhibitor on a lower metal layer is proposed. However, it is difficult to completely remove the diffusion barrier layer on the bottom of the via or the reaction inhibitor.

In a method of forming a metal interconnect of a semiconductor element according to an embodiment, the above-described method of selectively forming a layer using an ALD process may be applied to prevent a diffusion barrier layer from being formed on a bottom of a via and selectively form a metal interconnect.

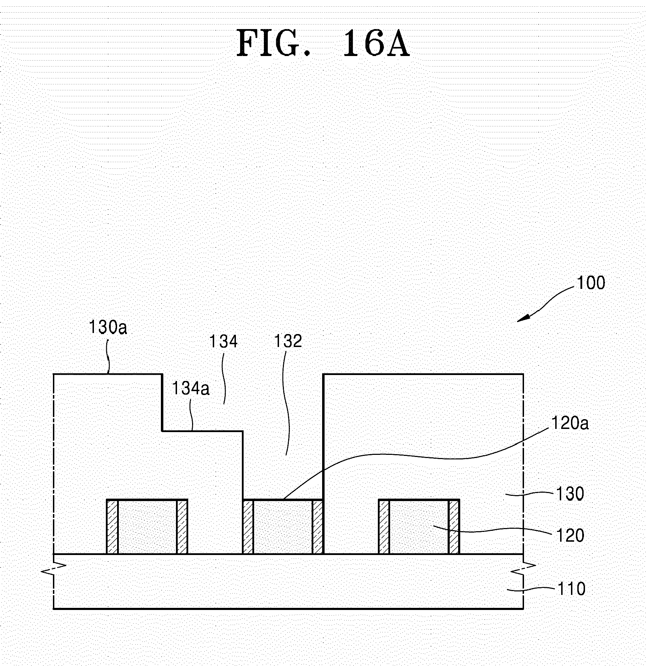

FIGS. 16A to 16E are cross-sectional views illustrating a method of forming a metal interconnect of a semiconductor element using an ALD process according to an embodiment.

Referring to FIG. 16A, a lower metal layer 120 and an interlayer insulating layer 130 covering the lower metal layer 120 may be positioned on a substrate 110 including a lower structure of a semiconductor element 100, and a via hole 132 exposing the lower metal layer 120 and a trench 134 in which an upper metal layer 146 is to be formed may be formed in the interlayer insulating layer 130. A bottom of the via hole 132 may correspond to an upper surface 120a of the lower metal layer 120. A portion of a bottom of the trench 134 may be the interlayer insulating layer 134a. A portion of the bottom of the trench 134 may correspond to an upper portion of the via hole 132. The lower metal layer 120 may include, for example, tungsten (W), copper (Cu), cobalt (Co), or ruthenium (Ru). The lower metal layer 120 may further include an additional layer such as a diffusion barrier layer. The diffusion barrier layer may include a metal nitride or a metal. The diffusion barrier layer may be made of, for example, titanium nitride, tantalum nitride, silicon nitride, tungsten nitride, hafnium nitride, molybdenum nitride, Co, Ta, Ti, or a combination thereof.

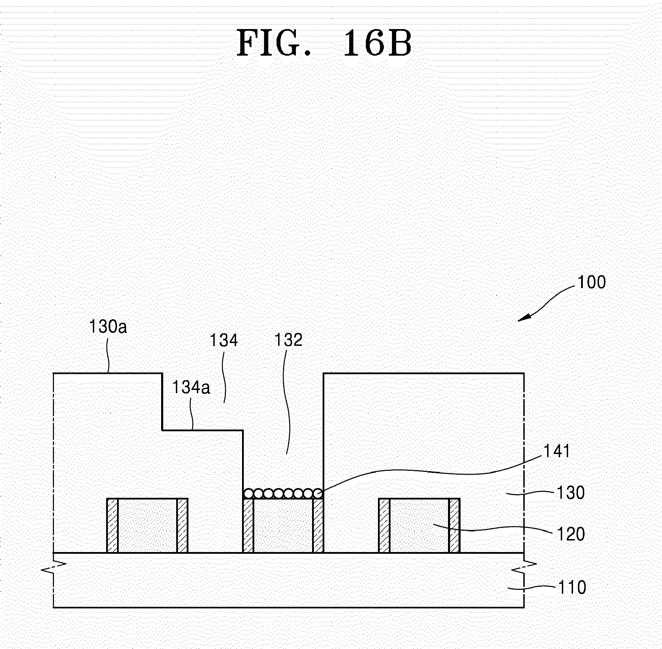

Referring to FIG. 16B, a reaction inhibition layer 141 may be selectively formed on the upper surface 120a of the lower metal layer 120 by injecting a reaction inhibitor. A reaction inhibitor may have selective adsorbability with respect to the lower metal layer 120 and may not be adsorbed on the interlayer insulating layer 130. Therefore, the reaction inhibitor may be predominantly adsorbed on the upper surface 120a of the lower metal layer 120 to form the reaction inhibition layer 141 and may not be adsorbed on sidewalls of the trench 134 and the via hole 132, a trench bottom 134a, and an upper surface 130a of the interlayer insulating layer 130. The reaction inhibitor may be, for example, a metal complex in which an organic ligand is bonded to a central metal. The central metal may include, for example, copper (Cu), aluminum (Al), tungsten (W), cobalt (Co), silver (Ag), gold (Au), platinum (Pt), iridium (Ir), rhodium (Rh), or ruthenium (Ru). The central metal may be, for example, the same metal as a metal of the lower metal layer 120.

The organic ligand may include, for example, a $C_5$-$C_{10}$ carbocyclic group unsubstituted or substituted with at least one $C_1$-$C_5$ alkyl group or at least one $C_1$-$C_5$ alkoxy group. The carbocyclic group may include, for example, Cp, CHD, COD, or benzene (Ph). The organic ligand including substituents may include, for example, $MeCp_2$, $EtCp_2$, $iPrCp_2$, 1-Me-1,4-CHD, $2,6,6$-$Me_3CHD_2$, $Me_2Cp_2$, or the like, but embodiments are not limited thereto. As used herein, Me may represent a methyl group, Et may represent an ethyl group, and iPr may represent an isopropyl group. The reaction inhibitor may include, for example, $Ru(EtCp)_2$, $Co(EtCp)_2$, $Ru(MeCp)_2$, $Co(MeCp)_2$, $(MeCp)_2WH_2$, $(EtCp)_2WH_2$, or Cp-CuPEts, but embodiments are not limited thereto. The reaction inhibition layer 141 may be a layer formed by adsorbing the reaction inhibitor on the upper surface 120a of the lower metal layer 120 in an energetically favorable form.

Optionally, as described in the embodiment of FIG. 13, when the reaction inhibitor includes a substituent, a reactant capable of reacting with the substituent to remove the substituent or substituting the reactant with a smaller substituent may be additionally introduced into an ALD process. Thus, as described above, it is possible to form a reaction inhibition layer having an improved layer density, that is, surface areal coverage.

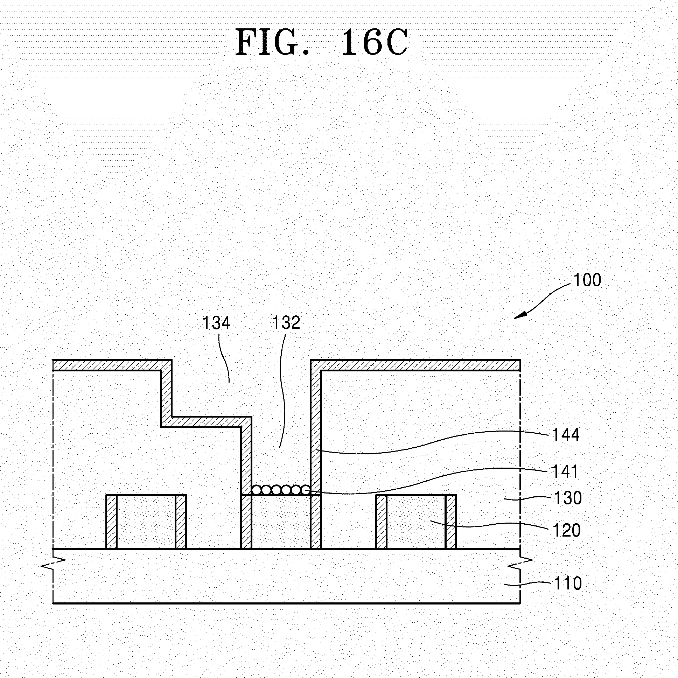

Referring to FIG. 16C, the diffusion barrier layer 144 may be formed on an exposed portion of the interlayer insulating layer 130 through an ALD process using a precursor for forming a diffusion barrier layer and a first reactant.

An appropriate precursor capable of forming a diffusion barrier layer may be used. As the precursor for forming a diffusion barrier layer, for example, $TiCl_4$, $Ti(NMe_2)_4$ (TDMAT), $TaCl_5$, $Ta(OEt)_2$, or the like may be used, but embodiments are not limited thereto. For example, $NH_3$ may be used as the first reactant capable of reacting with the precursor for forming a diffusion barrier layer. The first reactant may not react with the reaction inhibition layer 141 to form an atomic layer.

Since the precursor is not adsorbed on the upper surface 120a of the lower metal layer 120 on which the reaction inhibition layer 141 is formed, the diffusion barrier layer 144 may be not formed on the upper surface 120a of the lower metal layer 120. Therefore, the diffusion barrier layer 144 may be formed on the sidewalls of the trench 134 and the via hole 132, the trench bottom 134a, and the upper surface 130a of the interlayer insulating layer 130, and the reaction inhibition layer 141 may be formed on the upper surface 120a of the lower metal layer 120. The diffusion barrier layer 144 may be made of, for example, titanium nitride, tantalum nitride, silicon nitride, tungsten nitride, hafnium nitride, molybdenum nitride, Co, Ta, Ti, or a combination thereof.

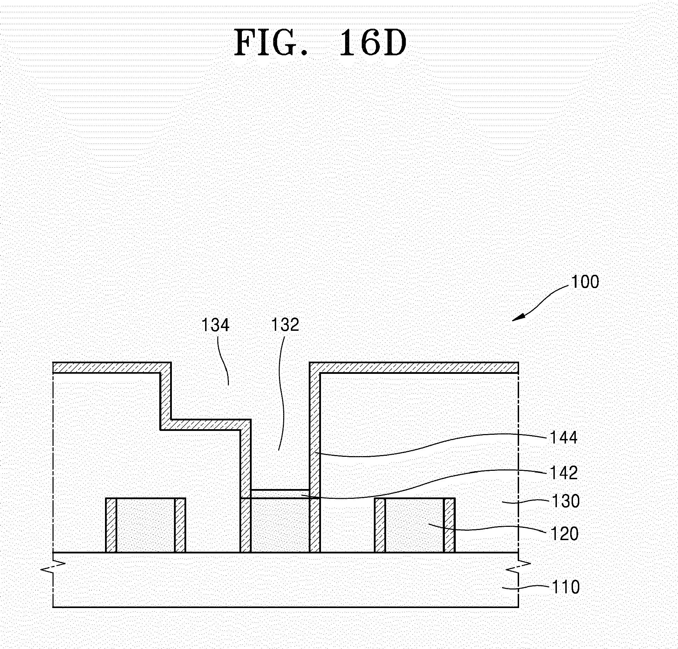

Referring to FIG. 16D, the reaction inhibition layer 141 on the upper surface 120a of the lower metal layer 120 may be converted into a metal bottom layer 142 using a second reactant. In this case, the reaction inhibitor of an embodiment serves as a precursor for forming the metal bottom layer 142. The second reactant may react with the reaction inhibition layer 141 to allow the reaction inhibition layer 141 to be converted into the metal bottom layer 142. In this case, the diffusion barrier layer 144 formed on the sidewalls of the trench 134 and the via hole 132, the trench bottom 134a, and the upper surface 130a of the interlayer insulating layer 130 may not be affected by the second reactant. The second reactant may include, for example, oxygen ($O_2$) or ozone (Os). Optionally, oxygen ($O_2$) or ozone (Os) may be an oxygen ($O_2$) or ozone (Os) plasma. The metal bottom layer 142 may be made of, for example, the same metal as the lower metal layer 120.

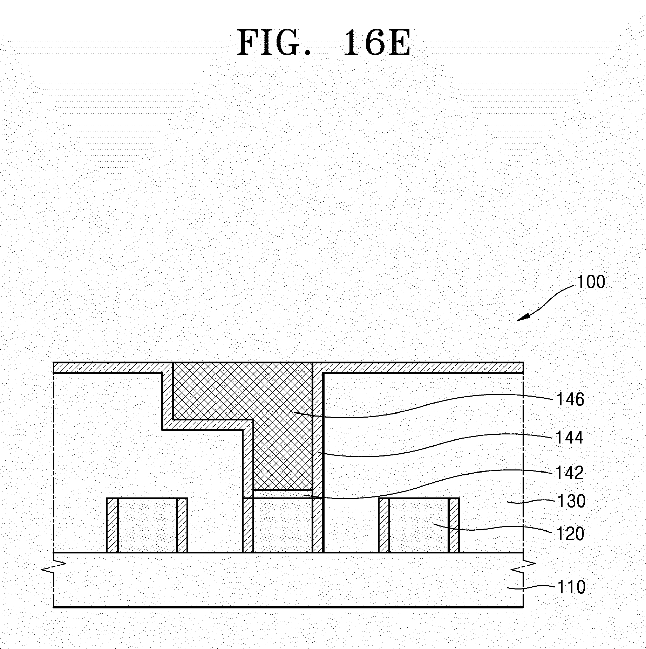

Referring to FIG. 16E, the upper metal layer 146 is formed in the via hole 132 and the trench 134. The upper metal layer 146 may be formed as a single layer or two or more layers. Since the upper metal layer 146 and the lower metal layer 120 are connected by the metal bottom layer 142, a problem of increasing series resistance of an interconnect may not occur.

Although a diffusion barrier layer has been described as an example in an embodiment, embodiments may be applied to layers which have various purposes and names and are formed together with a metal layer when a metal interconnect is formed.

Although the above-described method of selectively forming a layer using an ALD process and the method of forming an interconnect of a semiconductor element using the same have been described with reference to the embodiments shown in the drawings, embodiments are only illustrative, and it would be appreciated by those skilled in the art that various modifications and equivalent embodiments may be made. Therefore, the described embodiments should be considered in a descriptive sense only and not for purposes of limitation. The scope of the disclosure is defined not by the detailed description thereof but by the appended claims, and all differences within the scope will be construed as being included in the disclosure.

By using a reaction inhibitor for the formation of one atomic layer as a precursor for the formation of the other atomic layer, different deposition layers can be efficiently formed in the two regions, and a metal interconnect structure of a semiconductor device can be efficiently formed using the deposition layer.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A method of forming a layer according to atomic layer deposition, the method comprising:

   providing a substrate which comprises a first region comprising a first material and having a first surface, and a second region comprising a second material and having a second surface;
   forming a first reaction inhibition layer on the second surface using a reaction inhibitor selectively adsorbed on the second surface;
   selectively forming a first deposition layer on the first surface using a first precursor and a first reactant, wherein the first reactant reacts with the first precursor to form an atomic layer, and does not react with the reaction inhibitor to form the atomic layer; and
   converting the first reaction inhibition layer on the second surface into a second deposition layer using a second reactant which reacts with the first reaction inhibition layer to form the atomic layer.

2. The method of claim 1, wherein the first material comprises an insulator.

3. The method of claims 1 or 2, wherein the second material comprises a conductor;
   preferably wherein the conductor comprises copper (Cu), aluminum (Al), tungsten (W), cobalt (Co), silver (Ag), gold (Au), platinum (Pt), iridium (Ir), rhodium (Rh), or ruthenium (Ru).

4. The method of any of claims 1-3, wherein the reaction inhibitor comprises a metal complex comprising a central metal and an organic ligand;
   preferably wherein the central metal of the reaction inhibitor comprises copper (Cu), aluminum (Al), tungsten (W), cobalt (Co), silver (Ag), gold (Au), platinum (Pt), iridium (Ir), rhodium (Rh), or ruthenium (Ru).

5. The method of claim 4, wherein the organic ligand comprises a $C_5$-$C_{10}$ carbocyclic group unsubstituted or substituted with at least one $C_1$-$C_5$ alkyl group or at least one $C_1$-$C_5$ alkoxy group;
   preferably wherein the carbocyclic group comprises cyclopentadiene (Cp), cyclohexadiene (CHD), cyclooctadiene (COD), or benzene (Ph).

**6.** The method of claims 4 or 5, wherein the second material is a metal conductor,

wherein the reaction inhibitor comprises a metal complex in which an organic ligand is coupled to a central metal, and
wherein the second material and the central metal comprise a same metal.

**7.** The method of any of claims 1-6, wherein the reaction inhibitor comprises $M((R)_nCp)_2$, M comprises copper (Cu), aluminum (Al), tungsten (W), cobalt (Co), silver (Ag), gold (Au), platinum (Pt), iridium (Ir), rhodium (Rh), or ruthenium (Ru), R comprises methyl, ethyl, iso-propyl, or tert-butyl, and n is one of integers from 0 to 5.

**8.** The method of any of claims 1-7, wherein the first reactant comprises water ($H_2O$), ammonia ($NH_3$), or hydrogen ($H_2$), and
wherein the second reactant comprises oxygen ($O_2$) or ozone (Os).

**9.** The method of any of claims 1-8, wherein the forming the first reaction inhibition layer comprises alternately supplying the reaction inhibitor onto the substrate and supplying a third reactant onto the substrate one or more times, and then supplying the reaction inhibitor onto the substrate,

wherein the reaction inhibitor comprises a metal complex which comprises a central metal and an organic ligand comprising a substituent, and
wherein the third reactant reacts with the organic ligand to convert the substituent;
preferably wherein the third reactant and the first reactant comprise a same material.

**10.** A method of forming an interconnect of a semiconductor device, the method comprising:

providing a substrate comprising an interlayer insulating layer, wherein the interlayer insulating layer comprises a via hole configured to expose a lower metal layer and a trench on the via hole, and the trench comprises a first region connected to the via hole below the trench and a second region configured to expose the interlayer insulating layer;
selectively forming a first reaction inhibition layer on the lower metal layer using a reaction inhibitor selectively adsorbed on the lower metal layer;
selectively forming a diffusion barrier layer on an upper surface of the interlayer insulating layer and on an exposed portion of the interlayer insulating layer using a first precursor and a first reactant, wherein the first reactant reacts with the first precursor to form an atomic layer, and does not react with the reaction inhibitor to form the atomic layer;
converting the first reaction inhibition layer into a first metal layer using a second reactant which reacts with the reaction inhibitor to form the atomic layer; and
forming an upper metal layer in the via hole and the trench in which the diffusion barrier layer and the first metal layer are formed.

**11.** The method of claim 10, wherein the reaction inhibitor comprises a metal complex comprising a central metal and an organic ligand,

wherein the central metal comprises copper (Cu), aluminum (Al), tungsten (W), cobalt (Co), silver (Ag), gold (Au), platinum (Pt), iridium (Ir), rhodium (Rh), or ruthenium (Ru), and
wherein the organic ligand comprises cyclopentadiene (Cp), cyclohexadiene (CHD), cyclooctadiene (COD), or benzene (Ph) which is unsubstituted or substituted with at least one $C_1$-$C_5$ alkyl group or at least one $C_1$-$C_5$ alkoxy group;
preferably wherein the central metal of the reaction inhibitor comprises a same metal as a metal of the lower metal layer.

**12.** The method of claims 10 or 11, wherein the first precursor comprises $TiCl_4$, $Ti(NMe_2)_4$(TDMAT), $TaCl_5$, or $Ta(OEt)_2$.

**13.** The method of any of claims 10-12, wherein the first reactant comprises water ($H_2O$), ammonia ($NH_3$), or hydrogen ($H_2$), and
wherein the second reactant comprises oxygen ($O_2$).

**14.** The method of any of claims 10-13, wherein the diffusion barrier layer comprises titanium nitride, tantalum nitride, silicon nitride, tungsten nitride, hafnium nitride, molybdenum nitride, copper (Co), tantalum (Ta), titanium (Ti), or a combination thereof.

15. The method of any of claims 10-14, wherein the forming of the first reaction inhibition layer comprises alternately supplying the reaction inhibitor onto the substrate and supplying a third reactant onto the substrate one or more times, and then supplying the reaction inhibitor onto the substrate,

wherein the reaction inhibitor comprises a metal complex which comprises a central metal and an organic ligand comprising a substituent, and
wherein the third reactant reacts with the organic ligand to convert the substituent.

# FIG. 1

```
┌─────────────────────────────────┐
│   PROVIDE SUBSTRATE INCLUDING    │
│   FIRST REGION AND SECOND REGION │──── S10
└─────────────────────────────────┘
                 │
                 ▼
┌─────────────────────────────────┐
│   FORM FIRST REACTION INHIBITION │
│   LAYER IN SECOND REGION USING   │──── S20
│   FIRST REACTION INHIBITOR       │
└─────────────────────────────────┘
                 │
                 ▼
┌─────────────────────────────────┐
│   FORM FIRST DEPOSITION LAYER IN │
│   FIRST REGION USING FIRST       │──── S30
│   PRECURSOR AND FIRST REACTANT   │
└─────────────────────────────────┘
                 │
                 ▼
┌─────────────────────────────────┐
│ CONVERT FIRST REACTION INHIBITION│
│ LAYER INTO SECOND DEPOSITION     │──── S40
│ LAYER USING SECOND REACTANT      │
└─────────────────────────────────┘
```

# FIG. 2

# FIG. 3

# FIG. 4

Ru(EtCp)$_2$

Carish

INITIAL STATE

Ru(EtCp)$_2$ ADSORPTION

Carish ADSORPTION

$E_{ads}$ = 0 eV

$E_{ads}$ = −6.32 eV

$E_{ads}$ = +2.31 eV

EtCp-Ru

EtCp

# FIG. 5

Ru FILM GROWTH ON $SiO_2$ / Ru SUBSTRATE USING CARISH+$H_2O$

THICKNESS (nm) vs. EXPOSURE TIME AT CARISH (SECONDS)

# FIG. 6

# FIG. 7

Ru FILM GROWTH ON $SiO_2$ / Ru
SUBSTRATE USING $Ru(EtCp)_2 + H_2O$

THICKNESS (nm) vs EXPOSURE TIME AT $Ru(EtCp)_2$ (SECONDS)

# FIG. 8

# FIG. 9

# FIG. 10

# FIG. 11

(A)

AREAL COVERAGE OF 81.2%
BY EtCp–Ru AND EtCp

Areal Coverage Of 16.5% OF EtCp
TERMINAL SURFACE BY CARISH

(B)

AREAL COVERAGE OF 67.3%
By OHCp–Ru AND OHCp

AREAL COVERAGE OF 21.5% OF
OHCp TERMINAL SURFACE BY CARISH

(C)

AREAL COVERAGE OF 94.1%
BY OHCp–Ru and OHCp

AREAL COVERAGE OF 7.8%
OHCp TERMINAL SURFACE BY CARISH

# FIG. 12

```
┌─────────────────────────────────────┐
│      PROVIDE SUBSTRATE INCLUDING     │──── S10
│     FIRST REGION AND SECOND REGION   │
└─────────────────────────────────────┘
                    │
                    ▼
┌─────────────────────────────────────┐
│   FORM FIRST REACTION INHIBITION LAYER │
│  IN SECOND REGION USING FIRST REACTION │──── S20A
│  INHIBITOR AND THIRD REACTION INHIBITOR │
└─────────────────────────────────────┘
                    │
                    ▼
┌─────────────────────────────────────┐
│       FORM FIRST DEPOSITION LAYER IN   │
│    FIRST REGION USING FIRST PRECURSOR  │──── S30
│           AND FIRST REACTANT           │
└─────────────────────────────────────┘
                    │
                    ▼
┌─────────────────────────────────────┐
│     CONVERT FIRST REACTION INHIBITION  │
│       LAYER INTO SECOND DEPOSITION     │──── S40
│      LAYER USING SECOND REACTANT       │
└─────────────────────────────────────┘
```

# FIG. 13

# FIG. 14

# FIG. 15

# FIG. 16A

# FIG. 16B

# FIG. 16C

# FIG. 16D

# FIG. 16E